# EUROPEAN PATENT SPECIFICATION

(11) **EP 1 382 712 B1**
(45) Date of publication and mention of the grant of the patent: **21.05.2008**
(21) Application number: 02425446.8
(22) Date of filing: 08.07.2002
(51) Int. Cl.: C23C 14/50, C23C 16/50, C23C 16/458

(54) **Plant for vacuum coating of objects in batches**
Vorrichtung zur chargenweisen Vakuumbeschichtung von Gegenständen
Dispositif pour le revêtement de lots de substrats sous vide

(43) Date of publication of application: 21.01.2004
(73) Proprietor: Galileo Vacuum Systems S.R.L., 59100 Prato (IT)
(72) Inventor: Fanfani, Stefano, 50129 Firenze (IT)
(74) Representative: Mannucci, Michele

(56) References cited:
- US-A- 4 956 196
- US-A- 5 656 141
- US-A- 5 970 908

## Description

### Technical field

The present invention relates to a plant for metallization and deposition of a protective coating, both performed in a vacuum, and more particularly to a plant for the treatment of objects in batches, i.e. in which there is provided a vacuum chamber inside which the objects to be treated are arranged, supported and/or constrained on special part-carrying devices, so as to be subjected to the metallization or coating treatments. Once the process has been carried out, the vacuum chamber is opened in order to extract the treated objects and replace them with other objects to be treated.

### State of the art

Vacuum plants for the deposition of vaporized metal and plasma-energized protective layers on the internal and external surfaces of objects which require a high degree of uniformity and finishing quality are known.

These systems according to the prior art typically include a vacuum chamber of medium to large dimensions, a spacious movable or transportable rack for supporting a plurality of objects to be treated inside the chamber, means for moving the objects loaded onto the supports which are transported inside and outside the chamber, a plant for the production of vaporized metal and a supply of protective substance - such as a monomer - which is vaporized and deposited on the metallized surfaces.

After performing metallization by means of vaporization of metal (for example aluminum) bars inserted inside the vacuum chamber, the objects are coated with a polymer film obtained by means of introduction of suitable products which are blown inside the vacuum chamber and which are deposited on the surface of the metallized objects, resulting in polymerization and crosslinking. In some cases a similar treatment is also performed before metallization.

The use of a plasma created inside the vacuum chamber in the vicinity of the metallized objects is also typically used in order to energize the liquid monomer vaporized inside the vacuum chamber, so as to facilitate a uniform protective coating applied onto the objects.

The quality which is obtained in plasma coating technology for energization and application of the liquid monomer depends on the position of the discharge and the series of nozzles used to diffuse the monomer inside the vacuum chamber. In the prior art the spraying of the monomer occurs in a peripheral zone of the vacuum chamber, while the plasma source is positioned in another location, typically in a central zone inside the vacuum chamber. Therefore the vaporized liquid monomer entering the vacuum chamber must first be directed toward the plasma and then energized and diffused inside the vacuum chamber. This arrangement results in a premature and non-uniform deposition of the liquid monomer on the surface of the objects before it is completely energized by the plasma, partly negating the reason for which this arrangement is created inside the vacuum chamber.

US-A-4,842,893 describes a process and a plant for coating inside a vacuum chamber which allows a very rapid treatment and high level of finish to be obtained. This plant is designed for the continuous treatment of a plastic film or other substrate in sheet form and is not suitable for use in the treatment of products in batches.

US-A-5,895,531 describes a plant for the treatment of products in batches for metallization and deposition of the protective polymer film. In this plant an elongated cavity formed by an opening provided in the side wall of the vacuum chamber is envisaged. The latter is a vacuum chamber with a cylindrical extension and horizontal axis, inside which a carriage which supports the part-carrying device is inserted.

The cavity is therefore positioned in the peripheral zone of the vacuum chamber and substantially outside the main volume thereof. The cavity contains the high-voltage discharge electrode consisting of a conducting bar - located on the tangent to the wall of the vacuum chamber - and the monomer spraying device.

US-A-5,970,908 describes an apparatus which envisages positioning the discharge electrode for the production of plasma along an opening formed on the side wall of the vacuum chamber in a position tangential to the wall itself, this opening being equipped with a housing in the form of a cylinder segment which projects outside and which internally encloses the discharge electrode and the monomer spraying device. In this case also the positions of the discharge electrode and the spraying device are peripheral.

The configurations described above lead to a qualitative improvement in the protective film compared to the conventional arrangement which envisages an approximately central position of the discharge electrode and a peripheral position of the monomer spraying device. In fact, however, this qualitative improvement in the film is accompanied by a worsening as regards the productivity of the plant, i.e. the duration of each treatment cycle.

Indeed, such peripheral positioning of the assembly consisting of the discharge electrode and the monomer spraying device results in a very small volume which is affected by atomization of the energized monomer, with the consequent need to perform repeated passes over all the parts within the range of action of the device in question. A limited angle of action of the device thus located in an offset position results in the need for each part to pass several times in front of the housing of the device in order for the whole of its surface to be treated. In order to obtain more rapid treatment and therefore a reduction in the cycle times, it is necessary to arrange along the periphery of the vacuum chamber several discharge electrodes and several monomer diffusers, with a consequent increase in cost and complexity.

US-A-5.656.141 discloses a coating apparatus including a plasma source and a substrate carrier arranged above said plasma source.

### Objects and summarv of the invention

The present invention proposes providing a plant which is able to overcome this limitation in the process for deposition of the protective film on a number of parts treated in batches. This object is achieved with a plant according to claim 1. In fact, owing to a particular configuration of the vacuum chamber and the arrangement inside it of the metallization and coating means, the plant according to the invention is able to ensure polymer coating of the parts treated inside the vacuum chamber which is qualitatively better and the possibility of treating several parts simultaneously using relatively short cycles, with clear advantages for the production speed. In practice, owing to the invention it is possible to improve the quality of the protective film, obtaining a treatment speed which is higher than that of the prior art.

According to a first aspect, the present invention therefore envisages a plant comprising:
- a fixed body cooperating with at least one closing element, the closing element and the fixed body forming, in the closed condition, a vacuum chamber containing at least one support member or part-carrying system for supporting and moving the parts to be treated inside the chamber;
- associated with the support member, a series of electrified bars for supplying electric energy to vaporization sources, in which the metal to be vaporized inside the vacuum chamber is placed;
- at least one high-voltage discharge electrode for the production of plasma;
- a diffuser for vaporizing or in any case diffusing suitable products for the production of polymer film or the like;
- a housing, preferably with an arched shape, for housing the assembly comprising the discharge electrode and the diffuser, arranged inside the vacuum chamber, in an approximately central position, i.e. inside the carousel itself, for example and especially close to the longitudinal axis of the vacuum chamber, which may coincide with the axis of rotation of the part-carrying system.

"Position inside the chamber" is understood as meaning a position in the volume inside the perimetral wall of the chamber and preferably inside the volume occupied by the arrangement of the part-carrying devices mounted on the part-carrying system. Differently from that described in US-A-5,895,531 and in US-A-5,970,908, therefore, the diffuser and the discharge electrode are not located inside a niche formed in the perimetral wall, but inside the volume of the chamber, being protected and partially surrounded by the housing, consisting for example of a section in the form of a cylindrical surface. The discharge electrode and/or the diffuser may be integrally enclosed inside the volume surrounded by the housing, which generally has the form of a wall having a concave surface and a convex surface, forming a screen. However, it is also possible for one or both of these elements to project at least partly from the volume defined and enclosed by the housing. For example, the electrode could project at least partly from a semi-cylindrical volume defined and delimited by the wall forming the housing, although preferably both the elements are contained inside the volume defined by the housing itself.

Further 'advantageous features and embodiments of the plant according to the invention are indicated in the accompanying dependent claims and will be described in detail with reference to a non-limiting embodiment illustrated in the accompanying drawings.

The invention may be applied both to a plant with a chamber having a horizontal axis and frontally closing hatch and to plants with a vertical axis and especially plants with a double hatch.

According to a further aspect of the present invention, when the plant is of the vertical axis type, with a vacuum chamber formed by a fixed body and by at least one closing hatch, it is envisaged that, alongside the seal, between the fixed part of the vacuum chamber and the closing hatch, at least one housing having the form of a cylinder segment is arranged, said housing containing a discharge electrode - preferably arranged along the axis passing through the center of the cylinder of which the housing forms a segment - for forming the plasma, and a diffuser, preferably of tubular shape extending parallel to the conductor, but in a more peripheral - i.e. radially more external - position, inside the housing, for the distribution, inside the vacuum chamber, of a product suitable for forming the protective coating of the metallized objects. The diffuser - which will be advantageously equipped with calibrated holes of variable diameter in order to compensate for the drop in pressure inside it - is thus located in a zone of the vacuum chamber not far from the electrode.

As a result of the arrangement according to the present invention it is possible to optimize the quality of the protective polymer layer and - owing to the approximately central position of the diffuser and the electrode which are protected and partially surrounded by the housing - increase the visibility of the parts by the device in question in the sense that a greater area of the part-carrying device falls inside the range of action of the diffuser. Basically, owing to this arrangement, there is a widening in the effect of the device which - in the prior art - suffered from the limited action of the diffuser on the parts of the batch to be treated and this resulted in'a slower polymerization coating process. The diffuser may be single and extend over the necessary length or also two or more diffusers may be envisaged, where necessary each provided also with a single diffusion hole. Moreover, it is possible to envisage, inside the volume contained in the housing, a second diffuser for a different substance. The first diffuser may be able to diffuse a monomer intended for polymerization and/or crosslinking so as to form the protective film on the parts being processed, while the second diffuser may be used to diffuse a gas, for example argon or nitrogen, or air. This introduction of gaseous substance may serve for various purposes, for example for a so-called ion cleaning step, i.e. cleaning of the surface of the parts to be treated. In this function the diffuser arranged according to the invention is able to achieve, also for ion cleaning, the advantages which with the configuration in question are obtained for polymerization treatment. The introduction of gas into the vacuum chamber may also be performed during metallization, i.e. during vaporization of the metal bars inserted inside the vacuum chamber, in order to reduce, with the presence of the gas molecules, the mean path of the vaporized metal particles.

In a preferred embodiment of the invention the housings containing discharge electrode and diffuser may be two in number, located offset on the closing rabbet of the vacuum chamber in lateral positions with respect to the center.

In general, the housing may consist of a wall or a screen with cylindrical surfaces. "Cylindrical surface" is understood as meaning any lined surface defined by generatrix lines substantially parallel to each other and emerging from a directrix line. The directrix may be an arc of a circumference lying in a plane perpendicular to the direction of the generatrices, in which case the surface will be a straight circular cylindrical surface. However, the directrix could also have a different shape, for example an arc of an ellipse, a hyperbola or a parabola.

Further features associated with the form and the arrangement of this housing for the discharge electrode and diffuser are indicated in the dependent accompanying claims and will be described in greater detail with reference to the appended drawings, illustrating an advantageous and non-limiting embodiment of the invention.

### Brief description of the drawings

The invention will be better understood with reference to the description and the attached drawing which shows a practical non-limiting embodiment of the invention. More particularly, in the drawing:
Fig. 1 shows a front view of a vacuum chamber formed by a fixed body which is closed alternately by one or other of two closing hatches which are hinged on two opposite sides of the fixed body itself, each hatch being equipped with a respective part-carrying carousel;
Fig. 2 shows a plan view along II-II of Fig. 1;
Fig. 3 shows a plan view, on a larger scale, of one of the closing hatches shown in Fig. 2;
Fig. 4 shows a detailed plan view of the device according to the invention comprising the housing, the discharge electrode and the diffuser;
Fig. 5 shows a side view and partial longitudinal section through a plant with a horizontal chamber; and
Fig. 6 shows a cross section along VI-VI in Fig. 5.

### Detailed description of the preferred embodiments according to the invention

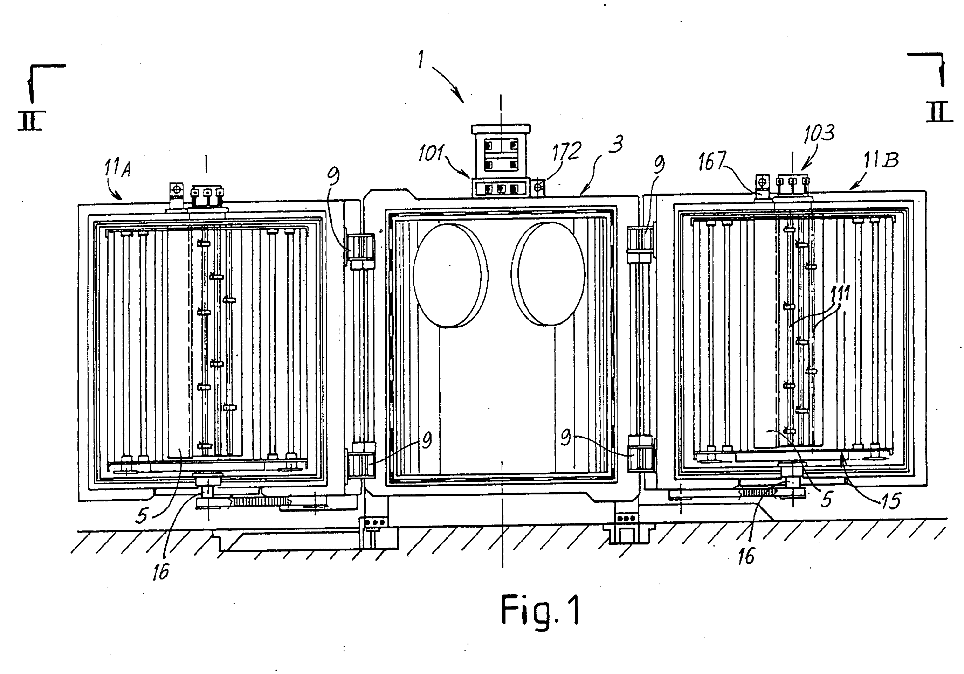

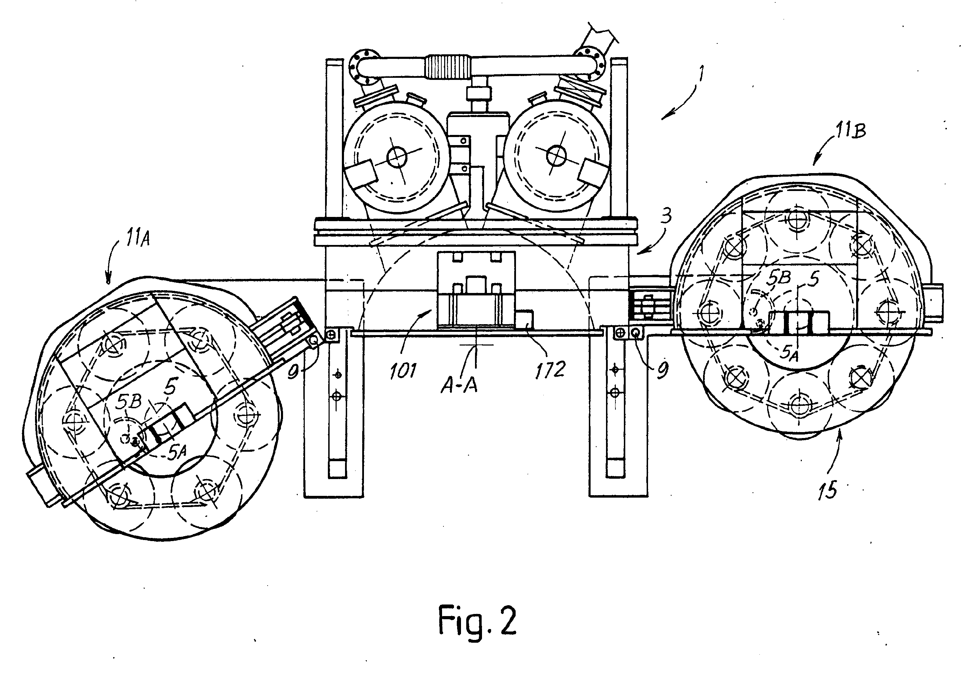

Figs. 1 and 2 show the general layout of a plant for vacuum metallization of objects treated in batches, of the vertical axis type, to which the present invention is applied. As mentioned, this is only one of the possible configurations of the plant to which the invention may be applied.

Generally the plant, denoted overall by 1, has a central body 3 which defines a portion of a cylindrical vacuum chamber with a vertical axis. Two closing hatches, indicated by 11A and 11B, are hinged on the two sides of the fixed central body 3, by means of hinges 9. In a manner known per se, the hatches 11A, 11B are closed alternately against the body 3 so as to complete and close the vacuum chamber which is therefore defined by the internal zone of the fixed body 3 and by the internal zone of one or other of the two hatches 11A, 11B. While the chamber is closed by one of the two hatches, the other hatch is accessible for discharging the parts treated during the previous cycle and insertion of parts to be treated in the cycle following the current treatment cycle.

As can be seen in particular in Fig. 2, the planwise extension of the closing hatches 11A, 11B is greater than the extension of the central body 3, such that the geometrical axis of the cylindrical vacuum chamber is located on the portion of the vacuum chamber formed by the closing hatch 11A or 11B which is in the closed condition. This allows assembly, inside each hatch, of a part-carrying system, indicated below as part-carrying support carousel, to which the objects or parts to be metallized are constrained. The carousel is indicated by 15. The carousel rotates about the axis A-A of the vacuum chamber and carries - in a manner known per se - rods parallel to the axis of rotation and rotating about their axis, such that the parts are moved with a planetary motion about the main axis A-A.

Electrified bars 111 associated with the respective hatch are arranged inside the vacuum chamber and are supplied with low-voltage current. In a manner known per se vaporization means are connected to the electrified bars 111 and are heated by the Joule's effect and heat to the vaporization temperature bars of metal, typically aluminum, inserted in said means.

The electrified bars are supported by the closing hatches 11A, 11B and are placed in electrical connection with a low-voltage current source by means of electrical contacts. A first series of fixed electrical contacts 101 is attached to the fixed body 3 of the plant, while another series of movable electrical contacts 103 is associated with each of the closing hatches 11A, 11B and is electrically connected to the electrified bars of the hatch itself. A fixed electrical contact 172 and a movable electrical contact 167 are arranged alongside the electrical contacts 101 and 103 for supplying the electrode 5B of each hatch 11A, 11B with a high voltage.

The hinges 9 allow the closing hatches 11A and 11B to be alternately moved toward and to be sucked against the fixed body 3, so as to define the vacuum chamber. After closing of either one of the two hatches, the fixed and movable electrical contacts are brought into contact with each other and closed so as to energize the electrified bars 111. In other configurations the hatches are associated with the fixed body in a different manner, for example by means of guides along which they are moved toward the fixed body, or are mounted on rotating carousels which move toward the fixed body one or other of at least two hatches.

The configuration described hitherto is known per se.

As can be seen in particular in Figs. 1 and 2, across the base or bottom of each of the two hatches 11A and 11B there extends a shaft 16, the axis of which coincides with the geometric axis of the cylindrical vacuum chamber which is defined when the respective hatch 11A or 11B is closed against the fixed body 3, this shaft 15 forming the rotational shaft for the part-carrying carousel 15 which is hinged on this shaft so that the racks constrained to them perform a planetary rotational movement about the central axis of the vacuum chamber, i.e. each rack performs a rotational movement about the central axis of the vacuum chamber and a simultaneous rotation about its axis.

Each of the hatches 11A and 11B has, associated with it, an assembly comprising a discharge electrode 5B and a diffuser 5A for introducing inside the vacuum chamber a substance which is deposited on the metallized objects and is polymerized so as to form a protective film. The discharge electrode 5B in the form of an elongated bar extending from the top of the respective hatch 11A, 11B downward and the diffuser 5B are contained in a housing 5 supported by the respective hatch.

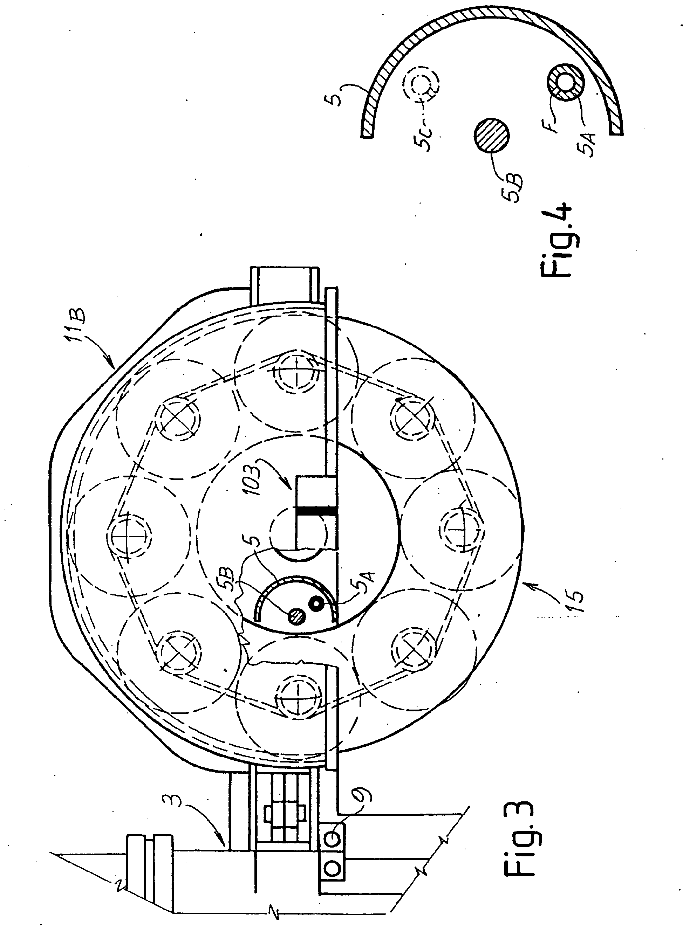

The assembly consisting of discharge electrode 5B and diffuser 5A with the housing 5 are shown in detail in the cross section according to Fig. 4. As can be seen in Fig. 4, the housing 5 has the form of a straight circular cylinder segment. The discharge electrode 5B is located along the axis of the cylinder of which the housing forms a segment. It extends longitudinally along approximately the whole axis of the cylinder, i.e. over approximately the entire height of the carousel 15. In a peripheral position, i.e. radially spaced from the cylinder axis, the diffuser 5A is arranged inside the housing 5.

The diffuser 5A consists of a tubular diffuser which extends from a top end to a bottom end parallel to the axis of the cylindrical surface defined by the housing 5 and to the discharge electrode 5B. The top end is connected to a duct supplying the product to be diffused inside the vacuum chamber, while the bottom end is closed. Calibrated holes F (Fig. 4) for outflow of the product are provided along the longitudinal extension of the tubular diffuser 5A. The holes have a diameter gradually increasing from the top end to the bottom end in order to compensate for the losses in head along the tubular diffuser itself.

The tubular diffuser 5A and the discharge electrode 5B, as well as the housing 5, are provided with suitable constraining devices by means of which they are constrained to the hatch 11.

As can be seen from Figs. 1 and 2, the location, inside the vacuum chamber, of the housing 5 for the assembly consisting of discharge conductor 5B and diffuser 5A is such that it does not occupy the zone of the internal volume of the vacuum chamber itself, which is formed when the hatch 11A or 11B is closed against the fixed body 3 of the plant, in which the parts to be treated are arranged.

A second diffuser, indicated by 5C in broken lines in Fig. 4, may be arranged inside the space protected by each housing 5, by means of which diffuser an inert gas, for example argon, may be blown into the vacuum chamber using a technique known per se.

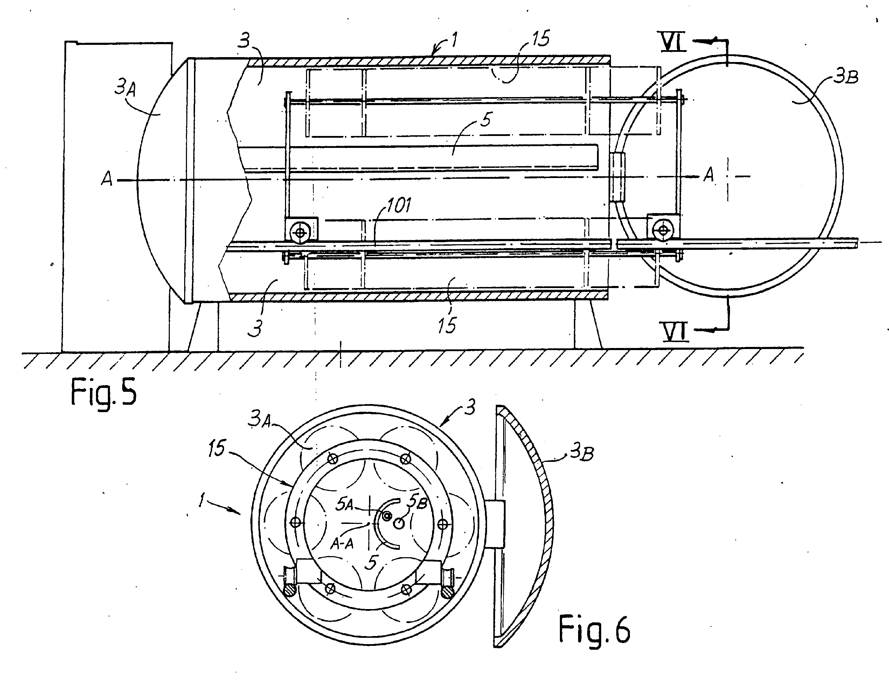

Figs. 5 and 6 show an embodiment of the invention with a plant with a horizontal chamber. The plant, which is again generally indicated by 1, has a vacuum chamber formed by a body 3 and having a substantially cylindrical internal shape with a horizontal axis A-A. The chamber has a bottom 3A and a facing closing hatch 3B which is hinged about a horizontal axis.

Guides 101 for insertion and extraction of a part-carrying system, again indicated by 15 and coaxial with the vacuum chamber 3 and rotatable about the axis A-A of the chamber itself, are arranged inside the vacuum chamber.

In the example shown, a wall forming a housing 5 of substantially semi-cylindrical shape, inside the volume of which a diffuser 5A and a discharge electrode 5B are arranged, extends from the end 3A of the vacuum chamber. The elements 5, 5A and 5B are substantially equivalent to the corresponding elements described with reference to Figs. 1 to 4. In an alternative configuration they may be supported by the part-carrying system 15. Moreover, again by way of alternative to the configuration shown, the hatch 3B could be integral with the part-carrying system 15 and movable therewith. In this case the arrangement of the elements 5, 5A, 5B could be supported by the hatch itself.

in the various possible configurations of the plant, also more than one assembly 5, 5A, 5B (and if necessary 5C) may be accommodated inside the vacuum chamber, said assemblies being substantially parallel to each other and if necessary oriented differently so as to act on several portions of the internal volume of the vacuum chamber. In this way a further reduction in the times of each processing cycle is obtained.

In the various configurations, the plasma may be of any type, generated by a direct current, alternating current, radiofrequency, microwave or other source.

It is understood that variations and modifications may be made to the invention, without thereby departing from the scope of the claims. The presence of any reference numbers in the accompanying claims has the purpose of facilitating reading thereof in the light of the preceding description and attached drawings, but does not limit in any way the scope of protection defined by the claims.

## Claims

1. A plant for vacuum metallization of objects treated in batches, comprising: a vacuum chamber; at least one part-carrying system (15) movable inside said vacuum chamber; at least one discharge electrode (5B); at least one diffuser (5A) associated with said discharge electrode for introduction of at least one fluid substance; a housing (5) containing at least partly said discharge electrode and/or said at least one diffuser; wherein said housing (5), said discharge electrode (5B) and said diffuser (5A) are elongated and extend parallel to a longitudinal axis (A-A), said discharge electrode and said diffuser being partially surrounded by said housing; **characterized in that** said housing is arranged inside said vacuum chamber, in an approximately central position.

2. Plant according to Claim 1, **characterized in that** said part-carrying system rotates about an axis of rotation (A-A) inside said vacuum chamber.

3. Plant according to Claim 1 or 2, **characterized in that** said housing has the form of a substantially semi-cylindrical wall surrounding at least partially said discharge electrode and said diffuser.

4. Plant according to one or more of the preceding claims, **characterized in that** said housing is arranged inside said part-carrying system (15).

5. Plant according to one or more of the preceding claims, **characterized in that** it comprises: a fixed body (3) cooperating alternately with one or other of two closing hatches (11A; 11 B) so as to define a vacuum chamber; on each of said two hatches a respective part-carrying system (15) movable inside said vacuum chamber when the plant is in operation; on each of said hatches, at least one high-voltage discharge electrode (5B); for each hatch (11A; 11 B) at least one diffuser (5A) supported by the respective hatch in the vicinity of the respective at least one discharge electrode; at least one housing (5) for the assembly consisting of the discharge electrode (5B) and the respective diffuser (5A) being provided on each hatch.

6. Plant according to Claim 5, **characterized in that** said housing (5), said discharge electrode (5B) and said diffuser (5A) of each hatch are located inside the volume defined by the respective hatch, in the vicinity of the longitudinal axis (A-A) of the vacuum chamber.

7. Plant according to Claim 5 or 6, **characterized in that** said hatches are hinged with said central body on opposite sides thereof about hinging axes substantially parallel to the axis (A-A) of the vacuum chamber, said axis being substantially vertical.

8. Plant according to one or more of Claims 1 to 4, **characterized in that** said vacuum chamber has a frontally closing hatch and a substantially horizontal longitudinal axis (A-A) and **in that** said part-carrying system can be inserted into and extracted from said vacuum chamber.

9. Plant according to Claim 8, **characterized in that** said housing (5), said discharge electrode (5B) and said diffuser (5A) have a horizontal extension substantially parallel to the axis (A-A) of said vacuum chamber.

10. Plant according to Claim 8 or 9, **characterized in that** said housing (5), said discharge electrode (5B) and said diffuser (5A) are movable with said part-carrying system so as to be inserted into said chamber and extracted therefrom.

11. Plant according to Claim 8 or 9, **characterized in that** said housing (5), said discharge electrode (5B) and said diffuser (5A) are mounted on an end of said chamber substantially opposite the hatch for closing thereof.

12. Plant according to one or more of the preceding claims, **characterized in that** said housing (5) for the assembly consisting of discharge electrode (5B) and diffuser (5A) has the form of an arched surface.

13. Plant according to Claim 12, **characterized in that** said housing has a shape of a cylindrical surface.

14. Plant according to Claim 12 or 13, **characterized in that** the discharge electrode (5B) and the diffuser (5A) are arranged inside the arc defined by the cross section of the housing (5).

15. Plant according to Claim 14, **characterized in that** the discharge electrode (5B) is located in the center of the arc of the respective housing (5) and the diffuser (5A) is located in a radially peripheral zone.

16. Plant according to at least Claim 5, **characterized in that** the vacuum chamber defined by said body and by said closing hatches has a substantially cylindrical shape with a circular cross section.

17. Plant according to one or more of the preceding claims, **characterized in that** said diffuser (5A) has a plurality of calibrated holes distributed along the longitudinal extension of said diffuser (5A) with a diameter increasing from a first end to a second end of said diffuser, the first end of the diffuser being connected to a duct supplying the product to be diffused inside the vacuum chamber and the second end being closed.

18. Plant according to one or more of the preceding claims, **characterized in that** a second diffuser (5C) for the introduction of a substance in the fluid state is associated with said at least one discharge electrode (5B).

19. Plant according to Claim 18, **characterized in that** said at least one diffuser (5A) has the function of introducing a substance for the formation of a protective layer deposited on the parts treated in the vacuum chamber and said second diffuser (5C) has the function of introducing a gas.

20. Plant according to Claim 18 or 19, **characterized in that** said second diffuser (5C) is enclosed in the volume protected by said housing (5).

21. Plant according to at least Claim 5, **characterized in that,** on each of said hatches (11A; 11B), the discharge electrode (5B), the diffuser (5A) and the housing (5) are located in the vicinity of the edge of the hatch which in the closed condition cooperates with the edge of the fixed body (3) so as to form and close said vacuum chamber and **in that** said housing has a convexity directed toward the axis of rotation (A-A) of the carousel (15).

22. Plant according to one or more of the preceding claims, **characterized in that** two or more of said housings (5) with corresponding discharge electrodes (5B) and diffusers (5A; 5C) are arranged inside said vacuum chamber.

23. Plant according to one or more of the preceding claims, **characterized in that** said part-carrying system comprises a carousel rotating about a main axis of rotation (A-A), and a series of part-carrying devices rotating about respective auxiliary axes parallel to the main axis of rotation, the parts thus being imparted a planetary motion inside the vacuum chamber.

## Patentansprüche

1. Anlage für die Vakuummetallisierung von Gegenständen, die chargenweise behandelt werden, mit: einer Vakuumkammer; mindestens einem Teil-Tragsystem (15), das im Inneren der Vakuumkammer beweglich ist; mindestens einer Entladungselektrode (5B); mindestens einem Diffusor (5A), welcher der Entladungselektrode für die Einleitung mindestens einer fluiden Substanz zugeordnet ist; einem Gehäuse (5), das mindestens teilweise die Entladungselektrode und/oder den mindestens einen Diffusor enthält; wobei das Gehäuse (5), die Entladungselektrode (5B) und der Diffusor (5A) gestreckt sind und sich parallel zu einer Längsachse (A-A) erstrecken, die Entladungselektrode und der Diffusor teilweise von dem Gehäuse umgeben sind; **dadurch gekennzeichnet, dass** das Gehäuse im Inneren der Vakuumkammer, in einer ungefähr zentralen Position, angeordnet ist.

2. Anlage gemäß Anspruch 1, **dadurch gekennzeichnet, dass** das Teil-Tragsystem um eine Rotationsachse (A-A) im Inneren der Vakuumkammer rotiert.

3. Anlage gemäß Anspruch 1 oder 2, **dadurch gekennzeichnet, dass** das Gehäuse die Form einer im Wesentlichen halbzylindrischen Wand aufweist, welche mindestens teilweise die Entladungselektrode und den Diffusor umgibt.

4. Anlage gemäß einem oder mehreren der vorhergehenden Ansprüche, **dadurch gekennzeichnet, dass** das Gehäuse im Inneren des Teil-Tragsystems (15) angeordnet ist.

5. Anlage gemäß einem oder mehreren der vorhergehenden Ansprüche, **dadurch gekennzeichnet, dass** sie umfasst: einen feststehenden Körper (3), der abwechselnd mit einer oder der anderen von zwei Verschlussluken (11A; 11B) zusammenwirkt, um so eine Vakuumkammer zu definieren; wobei auf jeder der zwei Luken ein jeweiliges Teil-Tragsystem (15) im Inneren der Vakuumkammer beweglich ist, wenn sich die Anlage in Betrieb befindet; auf jeder der Luken mindestens eine Hochspannungs-Entladungselektrode (5B); für jede Luke (11A; 11B) mindestens ein Diffusor (5A), der von der jeweiligen Luke in der Nähe der jeweiligen mindestens einen Entladungselektrode gestützt ist; mindestens ein Gehäuse (5) für die Baugruppe bestehend aus der Entladungselektrode (5B) und dem jeweiligen Diffusor (5A) auf jeder Luke vorgesehen ist.

6. Anlage gemäß Anspruch 5, **dadurch gekennzeichnet, dass** das Gehäuse (5), die Entladungselektrode (5B) und der Diffusor (5A) jeder Luke im Inneren des Volumens, das durch die jeweilige Luke definiert ist, in der Nähe der Längsachse (A-A) der Vakuumkammer angeordnet sind.

7. Anlage gemäß Anspruch 5 oder 6, **dadurch gekennzeichnet, dass** die Luken mit dem Zentralkörper auf gegenüberliegenden Selten davon um Schwenkachsen im Wesentlichen parallel zu der Achse (A-A) der Vakuumkammer schwenkbar sind, wobei die Achse im Wesentlichen senkrecht ist.

8. Anlage gemäß einem oder mehreren der Ansprüche 1 bis 4, **dadurch gekennzeichnet, dass** die Vakuumkammer eine stirnseitige Verschlussluke und eine Im Wesentlichen horizontale Längsachse (A-A) aufweist und dass das Teil-Tragsystem in die Vakuumkammer eingeführt und aus ihr herausgezogen werden kann.

9. Anlage gemäß Anspruch 8, **dadurch gekennzeichnet, dass** das Gehäuse (5), die Entladungselektrode (5B) und der Diffusor (5A) eine horizontale Ausdehnung aufweisen, die im Wesentlichen parallel zu der Achse (A-A) der Vakuumkammer ist.

10. Anlage gemäß Anspruch 8 oder 9, **dadurch gekennzeichnet, dass** das Gehäuse (5), die Entladungselektrode (5B) und der Diffusor (5A) mit dem Teil-Tragsystem beweglich sind, so dass sie in die Kammer eingeführt und daraus herausgezogen werden können.

11. Anlage gemäß Anspruch 8 oder 9, **dadurch gekennzeichnet, dass** das Gehäuse (5), die Entladungselektrode (5B) und der Diffusor (5A) an einem Ende der Kammer angebracht sind, das im Wesentlichen der Luke für deren Verschluss entgegengesetzt ist.

12. Anlage gemäß einem oder mehreren der vorhergehenden Ansprüche, **dadurch gekennzeichnet, dass** das Gehäuse (5) für die Baugruppe bestehend aus der Entladungselektrode (5B) und dem Diffusor (5A) die Form einer gebogenen Oberfläche aufweist.

13. Anlage gemäß Anspruch 12, **dadurch gekennzeichnet, dass** das Gehäuse die Form einer zylindrischen Oberfläche aufweist.

14. Anlage gemäß Anspruch 12 oder 13, **dadurch gekennzeichnet, dass** die Entladungselektrode (5B) und der Diffusor (5A) im Inneren des Bogens angeordnet sind, der durch den Querschnitt des Gehäuses (5) definiert ist.

15. Anlage gemäß Anspruch 14, **dadurch gekennzeichnet, dass** die Entladungselektrode (5B) im Mittelpunkt des Bogens des jeweiligen Gehäuses (5) angeordnet ist und der Diffusor (5A) in einer radial peripheren Zone angeordnet ist.

16. Anlage gemäß mindestens Anspruch 5, **dadurch gekennzeichnet, dass** die Vakuumkammer, die durch den Körper und durch die Verschlussluken definiert ist, eine im Wesentlichen zylindrische Form mit einem kreisförmigen Querschnitt aufweist.

17. Anlage gemäß einem oder mehreren der vorhergehenden Ansprüche, **dadurch gekennzeichnet, dass** der Diffusor (5A) eine Anzahl von kalibrierten Löchern aufweist, die entlang der Längsausdehnung des Diffusors (5A) verteilt sind, mit einem Durchmesser, der von einem ersten Ende zu einem zweiten Ende des Diffusors zunimmt, wobei das erste Ende des Diffusors mit einer Leitung verbunden ist, die das Produkt, das im Inneren der Vakuumkammer verteilt werden soll, zuführt, und das zweite Ende geschlossen ist.

18. Anlage gemäß einem oder mehreren der vorhergehenden Ansprüche, **dadurch gekennzeichnet, dass** ein zweiter Diffusor (5C) für die Einleitung einer Substanz im fluiden Zustand der mindestens einen Entladungselektrode (5B) zugeordnet ist.

19. Anlage gemäß Anspruch 18, **dadurch gekennzeichnet, dass** der mindestens eine Diffusor (5A) die Funktion aufweist, eine Substanz für die Bildung einer Schutzschicht, die auf Teilen abgeschieden wird, die in der Vakuumkammer behandelt werden, einzuleiten, und der zweite Diffusor (5C) die Funktion des Einleitens eines Gases aufweist.

20. Anlage gemäß Anspruch 18 oder 19, **dadurch gekennzeichnet, dass** der zweite Diffusor (5C) in dem Volumen, das durch das Gehäuse (5) geschützt ist, eingeschlossen ist.

21. Anlage gemäß mindestens Anspruch 5, **dadurch gekennzeichnet, dass** auf jeder der Luken (11A; 11B) die Entladungselektrode (5B), der Diffusor (5A) und das Gehäuse (5) in der Nähe des Randes der Luke angeordnet sind, die in dem geschlossenen Zustand mit dem Rand des feststehenden Körpers (3) zusammenwirkt, um so die Vakuumkammer zu bilden und zu schlie-ßen, und dass das Gehäuse eine Konvexität aufweist, die zu der Rotationsachse (A-A) des Karussells (15) ausgerichtet ist.

22. Anlage gemäß einem oder mehreren der vorhergehenden Ansprüche, **dadurch gekennzeichnet, dass** zwei oder mehr der Gehäuse (5) mit entsprechenden Entladungselektroden (5B) und Diffusoren (5A; 5C) im Inneren der Vakuumkammer angeordnet sind.

23. Anlage gemäß einem oder mehreren der vorhergehenden Ansprüche, **dadurch gekennzeichnet, dass** das Teil-Tragsystem ein Karussell umfasst, das um eine Hauptrotationsachse (A-A) rotiert, und eine Reihe von Teil-Tragvorrichtungen, die sich um jeweilige Hilfsachsen drehen, die parallel zu der Hauptrotationsachse sind, so dass den Teilen eine Planetenbewegung im Inneren der Vakuumkammer verliehen wird.

## Revendications

1. Dispositif pour la métallisation sous vide d'objets traités en lots, comprenant : une chambre sous vide; au moins un système de transport de pièces (15) pouvant se déplacer à l'intérieur de ladite chambre sous vide; au moins une électrode d'évacuation (5B); au moins un diffuseur (5A) associé ladite électrode d'évacuation pour une introduction d'au moins une substance fluidique; un logement (5) contenant au moins partiellement ladite électrode d'évacuation et/ou ledit au moins un diffuseur ; dans lequel ledit logement (5), ladite électrode d'évacuation (5B) et ledit diffuseur (5A) sont allongés et s'étendent de façon parallèle à un axe longitudinal (A-A), ladite électrode d'évacuation et ledit diffuseur étant partiellement entourés par ledit logement ; **caractérisé en ce que** ledit logement est disposé à l'intérieur de ladite chambre sous vide, dans une position approximativement centrale.

2. Dispositif selon la revendication 1, **caractérisé en ce que** ledit système de transport de pièces pivote autour d'un axe de rotation (A-A) à l'intérieur de ladite chambre sous vide,

3. Dispositif selon la revendication 1 ou 2, **caractérisé en ce que** ledit logement a la forme d'une paroi sensiblement semi-cylindrique entourant au moins partiellement ladite électrode d'évacuation et ledit diffuseur.

4. Dispositif selon une ou plusieurs des revendications précédentes, **caractérisé en ce que** ledit logement est disposé à l'intérieur dudit système de transport de pièces (15).

5. Dispositif selon une ou plusieurs des revendications précédentes, **caractérisé en ce qu'**il comprend : un corps fixe (3) coopérant de façon alternée avec un ou un autre parmi deux trappes de fermeture (11A, 11B) pour définir une chambre sous vide ; sur chacune desdites deux trappes un système de transport de pièces respectif (15) pouvant se déplacer à l'intérieur de ladite chambre sous vide lorsque le dispositif est en cours d'utilisation ; sur chacune desdites trappes, au moins une électrode d'évacuation de haute tension (5B); pour chaque trappe (11A, 11B) au moins un diffuseur (5A) supporté par la trappe respective dans l'environnement de ladite au moins une électrode d'évacuation respective ; au moins un logement (5) pour l'ensemble consistant en l'électrode d'évacuation (5B) et le diffuseur respectif (5A) étant fournis sur chaque trappe.

6. Dispositif selon la revendication 5, **caractérisé en ce que** ledit logement (5), ladite électrode d'évacuation (5B) et ledit diffuseur (5A) de chaque trappe sont situés à l'intérieur du volume défini par la trappe respective, dans l'environnement de l'axe longitudinal (A-A) de la chambre sous vide.

7. Dispositif selon la revendication 5 ou 6, **caractérisé en ce que** lesdites trappes sont articulées avec ledit corps central sur des côtés opposés de celui-ci autour d'axes d'articulation sensiblement parallèles à l'axo (A-A) de la chambre sous vide, ledit axe étant sensiblement vertical.

8. Dispositif selon une ou plusieurs des revendications 1. à 4, **caractérisé en ce que** ladite chambre sous vide a une trappe de fermeture frontale et un axe sensiblement horizontal (A-A) et **en ce que** ledit système de transport de pièces peut être insère dans ladite chambre sous vide et extrait de celle-ci.

9. Dispositif selon la revendication 8, **caractérise en ce que** ledit logement (5), ladite électrode d'évacuation (5B) et ledit diffuseur (5A) ont une extension horizontale sensiblement parallèle à l'axe (A-A) de ladite chambre sous vide.

10. Dispositif selon la revendication 8 ou 9, **caractérise en ce que** ledit logement (5), ladite électrode d'évacuation (5B) et ledit diffuseur (5A) peuvent être déplacés avec ledit système de transport de pièces pour être insérés dans ladite chambre et être extraits de celle-ci.

11. Dispositif selon la revendication 8 ou 9, **caractérisé en ce que** ledit logement (5), ladite électrode d'évacuation (5B) et ledit diffuseur (5A) sont montés sur une extrémité de ladite chambre sensiblement opposée à la trappe pour la fermeture de celle-ci.

12. Dispositif selon une ou plusieurs des revendications précédentes, **caractérisé en ce que** ledit logement (5) pour l'ensemble consistant en l'électrode d'évacuation (5B) et le diffuseur (5A) a la forme d'une surface arquée.

13. Dispositif selon la revendication 12, **caractérisé en ce que** ledit logement a la forme d'une surface cylindrique.

14. Dispositif selon la revendication 12 ou 13, **caractérisé en ce que** l'électrode d'évacuation (5B) et le diffuseur (5A) sont disposés à l'intérieur de l'arc défini par la coupe transversale du logement (5).

15. Dispositif selon la revendication 14, **caractérisé en ce que** l'électrode d'évacuation (5B) est située dans le centre de l'arc du logement respectif (5) et le diffuseur (5A) est situé dans une zone radialement périphérique.

16. Dispositif selon au moins la revendication 5, **caractérisé en ce que** la chambre sous vide définie par ledit corps et lesdites plaques de fermeture a une forme sensiblement cylindrique dotée d'une coupe transversale circulaire.

17. Dispositif selon une ou plusieurs des revendications précédentes, **caractérisé en ce que** ledit diffuseur (5A) a une pluralité de trous calibrés distribués le long do l'extension longitudinale dudit diffuseur (5A) dotés d'un diamètre augmentant à partir d'une première extrémité jusqu'à une deuxième extrémité dudit diffuseur, la première extrémité du diffuseur étant reliée à un conduit acheminant le produit destiné à être diffusé à l'intérieur de la chambre sous vide et la deuxième extrémité étant fermée.

18. Dispositif selon une ou plusieurs des revendications précédentes, **caractérisé en ce qu'**un deuxième diffuseur (5C) pour l'introduction d'une substance à l'état de fluide est associé a ladite au moins une électrode d'évacuation (5B).

19. Dispositif selon la revendication 18, **caractérisé en ce que** ledit au moins un diffuseur (5A) a pour fonction d'introduire une substance pour la formation d'une couche protectrice déposée sur les parties traitées dans la chambre sous vide et ledit deuxième diffuseur (5C) a pour fonction d'introduire un gaz.

20. Dispositif selon la revendication 18 ou 19, **caractérisé en ce que** ledit deuxième diffuseur (5C) est compris dans le volume protégé par ledit logement (5).

21. Dispositif selon au moins la revendication 5, **caractérisé en ce que**, sur chacune desdites trappes (11A, 11B), l'électrode d'évacuation (5B), le diffuseur (5A) et le logement (5) sont situés dans l'environnement du bord de la trappe qui dans la condition fermée coopère avec le bord du corps fixe (3) pour former et fermer ladite chambre sous vide et **en ce que** ledit logement a une convexité dirigée vers l'axe de rotation (A-A) du carrousel (15).

22. Dispositif selon une ou plusieurs des revendications précédentes, **caractérisé en ce que** deux ou plusieurs desdits logements (5) dotés d'électrodes d'évacuation correspondantes (5B) et de diffuseurs (5A, 5C) sont disposés à l'intérieur de ladite chambre sous vide.

23. Dispositif selon une ou plusieurs des revendications précédentes, **caractérisé en ce que** ledit système de transport de pièces comprend un carrousel pivotant autour d'un axe principal de rotation (A-A), et une série de dispositifs de transport de pièces pivotant autour d'axes auxiliaires respectifs parallèles à l'axe principal de rotation, un mouvement planétaire étant de ce fait attribué aux pièces à l'intérieur de la chambre sous vide.
